# EUROPÄISCHE PATENTSCHRIFT

(11) **EP 0 989 922 B1**
(45) Veröffentlichungstag und Bekanntmachung des Hinweises auf die Patenterteilung: **03.09.2003**
(21) Anmeldenummer: 98936209.0
(22) Anmeldetag: 18.06.1998
(51) Int. Cl.: B23P 21/00, H05K 13/04

(54) **MONTAGE- ODER FERTIGUNGSAUTOMAT UND ARBEITSSTATION FÜR EINEN SOLCHEN AUTOMATEN**
ASSEMBLY OR MANUFACTURING ROBOT AND WORK STATION FOR THE SAME
ROBOT DE MONTAGE OU DE FABRICATION ET POSTE DE TRAVAIL POUR UN TEL ROBOT

(30) Priorität: 21.06.1997 DE 19726374; 26.06.1997 DE 29711127 U; 02.07.1997 DE 19728264; 05.08.1997 DE 19733774
(43) Veröffentlichungstag der Anmeldung: 05.04.2000
(73) Patentinhaber: Feintool International Holding, 3250 Lyss (CH)
(72) Erfinder: Kumeth, Siegmund, 92224 Amberg (DE)
(74) Vertreter: Graf, Helmut, Dipl.-Ing.
(86) Internationale Anmeldenummer: DE9801666
(87) Internationale Veröffentlichungsnummer: WO98058763

(56) Entgegenhaltungen:
- EP-A- 0 401 808
- EP-A- 0 534 451
- EP-A- 0 749 270
- US-A- 5 031 295

## Beschreibung

Die Erfindung bezieht sich auf einen Montage- oder Fertigungsautomaten gemäß Oberbegriff Patentanspruch 1.

Montageautomaten dieser Art sind grundsätzlich bekannt (siehe, zum Beispiel, EP 0 749 270) und werden beispielsweise zum automatischen Fertigen oder Montieren von Bauelementen oder Baugruppen aus einzelnen Komponenten verwendet, die an Arbeitsstationen zugeführt werden und jeweils an den an den Aufnahmen vorgesehenen und mit diesen Aufnahmen an den Arbeitsstationen getaktet vorbeibewegten Bauteilen oder bereits teilweise montierten Baugruppen montiert werden, so daß die Bauelemente bzw. Baugruppen sukzessiv auf den Aufnahmen zusammengebaut bzw. montiert werden. Die Arbeitsstationen können teilweise auch als Prüfstationen ausgeführt sein. Jede Arbeitsstation befindet sich an einer Arbeitsposition. Insbesondere dann, wenn es sich bei den Bauteilen um solche mit sehr kleinen Abmessungen handelt, ist eine sehr maßgenaue und exakte Anordnung der Aufnahmen am Umfang des Tischelementes notwendig.

Aufgabe der Erfindung ist es, einen Fertigungsautomaten aufzuzeigen, der sich durch eine einfache und universell verwendbare Konstruktion auszeichnet, und zwar derart, daß dieser Fertigungsautomat (auch Grundeinheit) für unterschiedlichste Zwecke verwendet werden kann, wobei es nur notwendig ist, gewisse Funktionselemente dem jeweiligen Anwendungsfall entsprechend auszugestalten oder zu wählen. Zur Lösung dieser Aufgabe ist ein Fertigungsautomat entsprechend dem Patentanspruch 1 ausgebildet.

Weiterbildungen der Erfindung sind Gegenstand der Unteransprüche. Die Erfindung wird im Folgenden anhand der Figuren an einem Ausführungsbeispiel näher erläutert.
Es zeigen:
- Fig. 1: in vereinfachter Darstellung einen Vertikalschnitt durch einen Fertigungsautomaten gemäß der Erfindung;
- Fig. 2: eine Darstellung wie Fig. 1, jedoch in einer anderen Schnittebene;
- Fig. 3: in vereinfachter Darstellung eine Draufsicht auf den Fertigungsautomaten der Figuren 1 und 2;
- Fig. 4: in vergrößerter Darstellung ein Detail der Fig. 1;
- Fig. 5: in vereinfachter Darstellung und in Seitenansicht die Grundeinheit eines Montageautomaten;
- Fig. 6: in Teildarstellung eine Draufsicht auf den getaktet angetriebenen Drehtisch der Grundeinheit der Fig. 5;

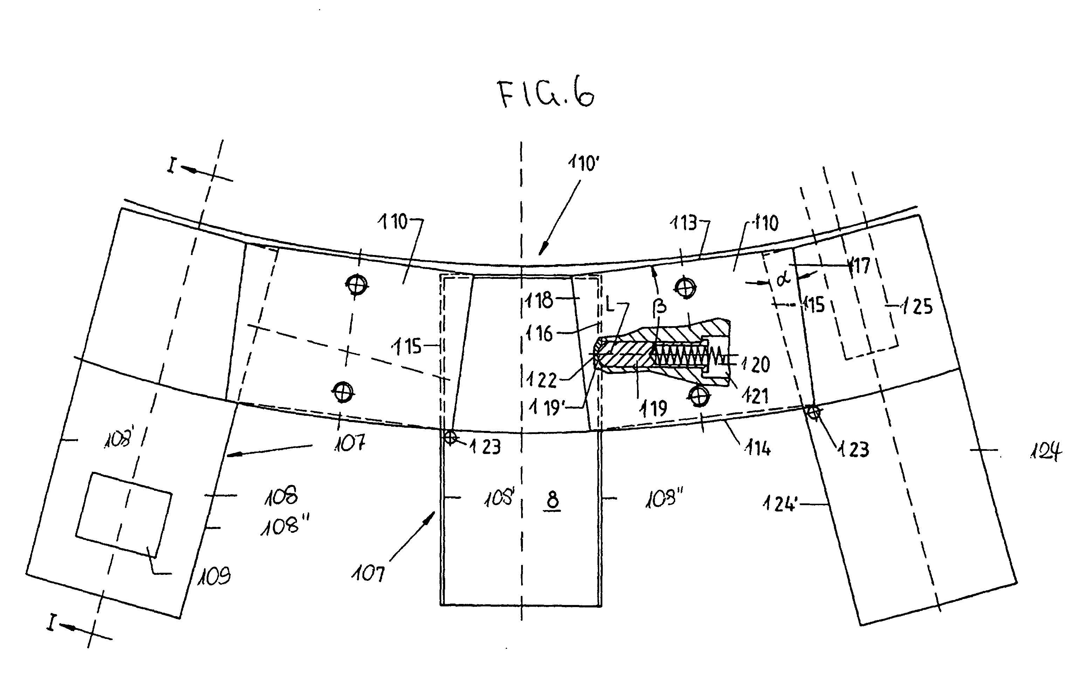

- Fig. 7: einen Schnitt entsprechend der Linie I-I der Fig. 6;
- Fig. 8: in Unteransicht eine der Halter für die Aufnahmen der Grundeinheit der Fig. 5;
- Fig. 9: in vereinfachter Darstellung und in Draufsicht eine abgewandelte Ausführungsform eines Halters zur Verwendung bei dem Montageautomaten der Fig. 5;
- Fig. 10: einen Schnitt entsprechend der Linie II - II der Figur 9.

Der in den Figuren dargestellte und dort allgemein mit 1 bezeichnete Fertigungsautomat dient zum Herstellen von Bauteilen oder Baugruppen aus einer Vielzahl von Einzelteilen, die im Fertigungsautomat maschinell zu dem jeweiligen Bauelement oder der Baugruppe zusammengesetzt bzw. montiert werden. Der Fertigungsautomat 1 eignet sich insbesondere zum Herstellen von sehr kleinformatigen mechanischen und/oder elektro-mechanischen Bauteilen, beispielsweise Mikroschaltern usw..

Der Fertigungsautomat besteht im wesentlichen aus einer Grundeinheit 2 und aus einer Vielzahl von Arbeitsstationen 3, die um eine vertikale Mittel- oder Maschinenachse V der Grundeinheit verteilt an dieser vorgesehen sind. An den Arbeitspositionen 3 sind beispielsweise Stationen 4 zum Zuführen von Komponenten vorgesehen, die Bestandteil der herzustellenden Baugruppe bzw. des herzustellenden Bauelementes sind und die an der jeweiligen Arbeitsposition an der dort vorbeigeführten, z.B. bereits teilmontierten Baugruppe montiert werden. Einige der Arbeitspositionen 3 sind beispielsweise auch Meß- und/oder Prüfpositionen. In den Figuren ist jeder Arbeitsposition 3 weiterhin eine Hubeinrichtung 5 mit einem Werkzeugträger 6 zugeordnet, der in der nachstehend noch näher beschriebenen Weise synchron mit dem Antrieb bzw. mit dem Arbeitstakt der Grundeinheit 2 einen horizontalen Hub (Doppelpfeil A) oder vertikalen Hub (Doppelpfeil B) ausführt, wobei der horizontale Hub vorzugsweise radial oder im wesentlichen radial zur Achse V erfolgt.

Die Grundeinheit 2 besitzt ein Maschinengestell oder Gehäuse 7, in welchem u.a. auch der nachstehend noch näher beschriebene mechanische Antrieb der Grundeinheit 2 vorgesehen ist und an welchem außen ein ringförmiger, von einer Vielzahl von Segmenten gebildeter und am Umfang polygonartiger überstehender Tisch 8 befestigt ist, der zur Lagerung bzw. Befestigung der Funktionselemente 4 der Arbeitsstationen 3 dient. Dieser Tich 8 ist an dem unteren Abschnitt 7' des Maschinengestells 7 vorgesehen.

An der Oberseite besitzt das Maschinengestell 7 einen Abschnitt 7" mit reduziertem Querschnitt, an welchem eine die Achse V konzentrisch umschließende vertikale Säule 9 mit ihrem unteren Ende befestigt ist, die über die Oberseite des Abschnittes 7" vorsteht. An der Säule 9 ist eine Hohlwelle 10 drehbar gelagert, die mit ihrem oberen Ende an einem Rotor oder drehbaren Tischelement 11 befestigt ist. Am unteren Ende der Hohlwelle 10 und innerhalb des Abschnittes 7" bzw. des Maschinengehäuses ist ein Antriebsrad 12 befestigt, welches an seinem Umfang mit einer Malteser-Verzahnung ausgebildet ist, mit einem Malteser-Exzenter 13 zusammenwirkt und zusammen mit diesem einen Malteser-Antrieb derart bildet, daß bei kontinuierlich um eine vertikale Achse parallel zur Achse V angetriebenem Exzenter 13 das Antriebsrad 12 und damit auch das Tischelement 11 eine getaktete Drehbewegung um die Achse V ausführt, und zwar mit Drehschritten und dazwischenliegenden Stillstandszeiten. Das zeitliche Verhältnis zwischen Bewegungszeit und Stillstandszeit ist bei kontinuierlich umlaufendem Exzenter 13 1/1. Der Malteser-Antrieb ist weiterhin so ausgebildet, daß während der Stillstandszeit das Antriebsrad 12 spielfrei gegen Verdrehen blockiert ist, und zwar durch eine entsprechende Steuerfläche des Exzenter- oder Malteser-Antriebes 13.

An der nicht drehenden Säule 9 ist oberhalb des Tischelementes 11 ein Tischelement 14 befestigt, welches ebenso wie das Tischelement 11 kreisscheibenförmig ausgebildet ist und mit seiner Achse achsgleich mit der Achse V liegt. Das Tischelement 11 steht mit einem Umfangsbereich 11' über den Rand des Tischelementes 14 vor. An dem Umfangsbereich 11' sind Aufnahmen 15 befestigt, von denen jede zur Aufnahme einer Baugruppe dient und an ihrer Oberseite ein entsprechendes Nest" aufweist, in dem die Baugruppen jeweils in einer genau vorgegebenen Orientierung und Positionierung angeordnet sind. Der Malteser-Antrieb 12/13 ist weiterhin so ausgebildet, daß in jedem Arbeitstakt, der aus einem Bewegungsschritt und einer anschließenden Stillstandszeit besteht, die Aufnahmen 15 um eine Maschinenteilung um die Achse V weiterbewegt werden. Die Arbeitspositionen 3 sind dieser Maschinenteilung entsprechend um die Achse V angeordnet.

Mit einem an dem Träger 6 der Hubeinrichtung 5 vorgesehenen Werkzeug, beispielsweise Greifer erfolgt dann an den Arbeitspositionen 3 z.B. das Entnehmen jeweils einer Komponente, die an dem Funktionselement 53 bzw. an der Zuführung der Arbeitsstation 4 bereitsteht, und dann bei stillstehender Aufnahme 15 durch die vertikale Bewegung des Trägers 6 (Doppelpfeil B) das Einsetzen dieser Komponente in die sich an der betreffenden Arbeitsstation 3 befindliche Baugruppe, so daß die an den Aufnahmen 15 angeordneten Baugruppen durch Weiterbewegen von Arbeitsstation zu Arbeitsstation zunehmend zusammengebaut und schließlich an einer als Entnahmestation ausgeführten Arbeitsposition durch ein am dortigen Träger 6 vorgesehenes Werkzeug als fertig montierte Baueinheit entnommen und an einen Transporteur zum Abführen der fertig montierten Bauelemente bzw. Baueinheiten abgegeben werden können.

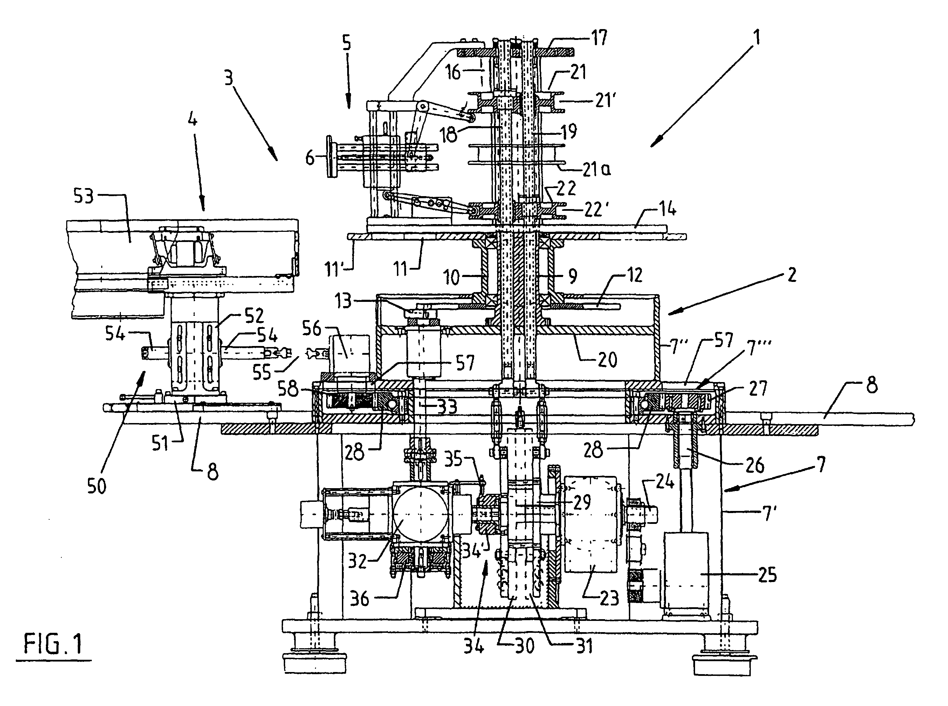

Oberhalb des Tischelementes 14 setzt sich die vertikale Säule 9 in mehreren, d.h. bei der dargestellten Ausführungsform in vier vertikalen Stangen 16 fort, von denen in der Fig. 1 der deutlicheren Darstellung wegen nur eine angedeutet ist und die in Draufsicht auf die Grundeinheit 2 um die Achse V derart verteilt sind, daß die Achsen der Stangen 14 die Eckpunkte eines Quadrates bildet, dessen Mittelpunkt mit der Achse V zusammenfällt. Die unteren Enden der vertikalen Tragstangen 16 sind mit dem oberen, festen Tischelement 14 verbunden. An den oberen Enden der Tragstangen 16 ist eine Tragplatte 17 befestigt.

In der Säule 9 bzw. in dem Raum zwischen den Stangen 16 sind bei der dargestellten Ausführungsform radial gegenüber der Achse V versetzt und zu dieser parallel zwei Hubstangen 18 und 19 in vertikaler Richtung verschiebbar vorgesehen. Die Hubstangen 18 und 19 sind in der oberen Tragplatte 17 sowie auch in einer Platine 20 im Inneren des Maschinengestells 7 bzw. des Abschnittes 7' um einen vorgegebenen axialen Hub verschiebbar vorgesehen, und zwar in der nachstehend noch näher beschriebenen Weise synchron mit dem zentralen Antrieb der Grundeinheit 2, wobei die Hubstange 18 zur Erzeugung der horizontalen Bewegung (Doppelpfeil A) sämtlicher Hubeinrichtungen 5 und die Hubstange 19 zur Erzeugung der vertikalen Bewegung (Doppelpfeil B) sämtlicher Hubeinrichtungen 5 dient. An den Hubstangen 18 und 19 sind radartige Steuerscheiben 21 und 22 vorgesehen, die jeweils seilscheibenartig mit einer zur kreisringförmigen Umfangsfläche hin offenen Umfangsnut 21' bzw. 22' ausgebildet sind. Die Steuerschrauben 21 und 22 besitzen weiterhin mehrere Öffnungen. Durch diese Öffnungen sind sowohl bei der Steuerscheibe 21, also auch bei der Steuerscheibe 22 sämtliche Stangen 16 und die Hubstangen 18 und 19 hindurchgeführt. Die in der Fig. 1 obere Steuerscheibe 21 ist gleitend auf den Stangen 16 sowie auf der Hubstange 19 geführt und mit der Hubstange 18 fest verbunden. Die in den Figuren untere Steuerscheibe 22 ist gleitend auf den Stangen 16 und der Hubstange 18 geführt und mit der Hubstange 19 fest verbunden, so daß die Steuerscheibe 21 ausschließlich mit der Hubstange 18 und die Steuerscheibe 22 ausschließlich mit der Hubstange 19 auf- und abbewegt wird.

Nachfolgend werden der zentrale Antrieb der Grundeinheit, die Hubeinheiten sowie die Funktionselemente 4 näher beschrieben.

### Zentraler Antrieb der Grundeinheit 2

Der Antrieb der Grundeinheit 2 besteht aus einem in den Figuren nicht dargestellten Elektromotor, der in dem Maschinengestell 7 untergebracht ist und zum Antrieb sämtlicher Elemente der Grundeinheit dient. Die Ausgangswelle des Elektromotors ist mit einem Winkelgetriebe 23 verbunden, dessen Ausgangswelle 24 beidseitig aus dem Gehäuse dieses Winkelgetriebes herausgeführt ist. Mit dem einen Ende der Welle 24 wird über eine Getriebeanordnung 25 eine Welle 26 angetrieben, die mit ihrer Achse parallel zur Achse V im Inneren des Maschinengestells 7 drehbar gelagert ist und über ein an dieser Welle vorgesehenes Ritzel 27 einen Zahnkranz 28 antreibt, der um die Achse V drehbar im Maschinengestell 7 gelagert ist. Der Zahnkranz 28 dient in der nachstehend noch näher beschriebenen Weise zum Antrieb von speziellen Funktionselementen der Arbeitsstationen 4.

Auf dem anderen Ende der Welle 24 ist ein Träger 29 für zwei Kurvenscheiben 30 und 31 vorgesehen. Weiterhin treibt dieses Ende der Welle 24 ein als Winkelgetriebe ausgebildetes Getriebe 32 an, dessen vertikale Ausgangswelle 33 den Exzenter 13 oder Malteser-Antrieb 12/13 antreibt. Im Antriebsstrang zwischen dem Träger 29 und dem Eingang des Getriebes 32 befindet sich eine Sicherheitskupplung 34, die bei Überschreiten eines vorgegebenen Drehmomentes mechanisch ausrastet und das Getriebe 32 vom Antrieb abtrennt. Die Sicherheitskupplung 34 besitzt hierbei ein axial verschiebbares Teil 34', welches bei ausgerasteter Sicherheitskupplung eine gegenüber der Normalstellung axial verschobene Position einnimmt. Die Position des Teiles 34' wird mit einem elektrischen Sensor 35 ständig abgefragt bzw. überwacht. Dieser Sensor 35 steuert eine am Getriebe 32 vorgesehene elektromagnetische Bremse 36, die bei Ansprechen der Sicherheitskupplung 34 das Getriebe 32 sofort aufgrund des Signals des Sensors 35 blockiert und diese Blockade solange aufrecht erhält, bis die Sicherheitskupplung 34 wieder eingerastet bzw. der Antrieb über die Sicherheitskupplung wieder hergestellt ist. Das Einrasten der Sicherheitskupplung 34 erfolgt durch langsames Drehen der Welle 24 in einer Drehrichtung, die der normalen Drehrichtung beim Betrieb der Grundeinheit 2 entgegengesetzt ist.

Die Sicherheitskupplung 34 ist weiterhin so ausgebildet, daß das Wiedereinrasten der Sicherheitskupplung 34, d.h. das Wiederherstellen der Antriebsverbindung über diese Kupplung nur in einer einzigen Relativlage des Eingangs und des Ausgangs dieser Kupplung möglich ist, so daß nach jedem Wiedereinrasten der angesprochenen Sicherheitskupplung 34 insbesondere auch durch die Blockierung des Getriebes 32 eine vorgegebene Phasenlage zwischen der Drehstellung der Kurvenscheiben 30 und 31 und der Drehstellung des Antriebsrades 12 wieder hergestellt ist. Durch die Blockierung des Getriebes 32 bei angesprochener bzw. ausgerasteter Sicherheitskupplung 34 gewährleistet, daß das Tischelement 11 bei ansprechender Sicherheitskupplung 34 sofort gestoppt und keine die Phasenlage zwischen den Kurvenscheiben 30 und 31 und der Stellung des Tischelementes 11 verändernde Relativbewegung möglich ist.

Der Antrieb der Hubstangen 18 und 19 erfolgt über jeweils eine Schwinge 37 bzw. 38, die im Maschinengestell 7 jeweils um eine Achse parallel zur Achse der Welle 24 schwenkbar gelagert sind. Die Schwinge 37 für die Hubstange 18 ist als einarmiger Hebel ausgeführt, der an einem Ende schwenkbar gelagert ist und an seinem anderen Ende mit einer Kurvenrolle 39 auf dem oberen Teil der Kurvenscheibe 30 aufliegt. Das freie Ende der Schwinge 37 ist über einen Doppelgelenk-Zwischenhebel 40 mit dem unteren Ende der Hubstange 18 verbunden, so daß die Hubstange 18 der Form der Umfangsfläche der Kurvenscheibe 30 folgend auf- und abbewegt wird. Die Schwinge 38 für die Hubstange 19 ist als doppelarmiger, abgewinkelter Hebel ausgebildet, der im mittleren Bereich schwenkbar gelagert ist, an einem Ende eine Kurvenrolle 41 trägt, die durch Federn 42 gegen die Umfangsfläche der Kurvenscheibe 31 angepreßt anliegt.

Das andere Ende der Schwinge 38 ist über einen Doppelgelenk-Zwischenhebel 43 mit dem unteren Ende der Hubstange 19 verbunden.

Durch die Befestigung der Kurvenscheiben 30 und 31 an dem Träger 29 ist ein justieren der Kurvenscheibn durch Verstellen dieser Scheiben um die Achse der Welle 24 möglich. Durch nicht dargestellte Befestigungsmittel sind die Kurvenscheiben am Träger 29 fixierbar.

Die Getriebeanordnung 32 mit der Bremse 36 und dem Sensor 35 bildet eine austauschbare Baueinheit. Vorzugsweise sind dann für ein und dieselbe Grundeinheit 2 mehrere, beispielsweise vier unterschiedliche Getriebe 32 austauschbar vorgesehen, und zwar derart, daß mit einem ersten Typ des Getriebes 32 bei kontinuierlich angetriebener Eingangswelle ein kontinuierlicher Antrieb der Welle 33 erreicht wird und sich somit in der oben bereits erwähnten Weise über den Malteser-Antrieb 12/30 ein Verhältnis Bewegungszeit/Stillstandszeit von 1/1 ergibt.

Andere Typen des Getriebes 32 sind so ausgebildet, daß bei kontinuierlich umlaufender Eingangswelle dieses Getriebes die Welle 33 eine sich periodisch ändernde Drehgeschwindigkeit aufweist, und zwar durch Verwendung entsprechender Ellipsen-Zahnräder im Getriebes 32 derart, daß z.B. bei einem zweiten Typ des Getriebes das Verhältnis Bewegungszeit /Stillstandszeit 1,8/1, bei einem dritten Typ des Getriebes 32 das Verhältnis Bewegungszeit /Stillstandszeit 1/4,3 und bei einem vierten Typ das Verhältnis Beewegungszeit /Stillstandszeit 1/1,8 beträgt.

Die Kurvenscheiben 30 und 31 sind so ausgeführt, daß jede Hubstange 18 und 19 in jedem Arbeitstag einen vollen Hub aus einer Ausgangsstellung in eine Arbeitsstellung und zurück in die Ausgangsstellung ausführt.

Bei dem vorgenannten dritten und vierten Typ des Getriebes 32 können auch Kurvenscheiben 30 und/oder 31 verwendet werden, derart, daß zumindest eine der Hubstangen 18 und 19 während eines Arbeitstaktes zwei Hubbewegungen ausführt, beispielsweise die Hubstange 19 zum Montieren eines Funktionselementes und zum anschließenden Wenden oder Prüfen der Baueinheit in der Aufnahme 15 oder dem dortigen Nest.

### Arbeitsstation 4

Sämtliche Arbeitsstationen 4 sind weitestgehend standardisiert ausgeführt, und zwar bei der dargestellten Ausführungsform im wesentlichen zweiteilig. Jede Arbeitsstation besteht aus einer Basis 50, die aus einer Aufspann- bzw. Befestigungsplatte 51 und einem Träger 52 besteht und mit einer unteren Aufspann- bzw. Befestigungsplatte 51 an dem Tisch 8 befestigbar ist, und zwar mit Hilfe von Schrauben oder anderen geeigneten Befestigungselementen. Die Befestigungsmittel für die Aufspannplatte 51 am Tisch 8 sind ebenfalls standardisiert, und zwar derart, daß die Befestigung der Basis 50 am Tisch 8 in der jeweils erforderlichen Position und Orientierung ohne zusätzliche Arbeiten am Tisch 8 möglich ist. Insbesondere ist eine Einstellung der Basis 50 hinsichtlich des radialen Abstandes von der Achse V sowie auch hinsichtlich der Orientierung einer horizontalen Achse C der Basis 50 möglich.

Speziell für diese Orientierung der Achse C ist der Träger 52 einstellbar (beispielsweise drehbar) und in der jeweiligen Einstellung fixierbar an der Aufspannplatte 51 vorgesehen. An der Oberseite des Trägers 52 ist das für die jeweilige Arbeitsstation 4 typische Teil 53 vorgesehen, beispielsweise eine Zuführung für ein bestimmtes Bauelement. Auch dieser an das jeweilige Bauelement stärker angepaßte Teil der Arbeitsstation 4 kann wiederum aus teilweise standardisierten Komponenten bestehen. Eine Besonderheit besteht darin, daß die Basis 50 eine achsgleich mit der Achse C angeordnete und in dem Träger 52 drehbar gelagerte Welle 54 aufweist, die mit wenigstens einer in dem Gehäuse des Trägers 52 untergebrachten Steuereinrichtung für den Antrieb von aktiven Elementen des Funktionsteiles 53 antriebsmäßig verbunden ist. Beispielsweise ist auf der Welle 54 wenigstens eine Kurvenscheibe zum Steuern von Wippen, Schiebern usw. vorgesehen, die Bestandteil des Funktionsteiles 53 sind. Über die Welle 54 und die Steuer- oder Getriebeanordnung ist eine rein mechanische Steuerung solcher Funktionselemente der Arbeitsstation 4 möglich, und zwar mit hoher Geschwindigkeit, verzögerungsfrei und exakt synchron mit dem Antrieb der Grundeinheit 2.

Die Welle 54 ist über eine Gelenkwelle 55 mit einem Winkelgetriebe 56 verbunden, welches auf dem horizontalen Absatz 7"' des Maschinengestells 7 befestigt ist, und zwar an einer dort vorgesehenen Öffnung 57. Das Winkelgetriebe 56 ist im Bereich dieser Öffnung an dem Absatz 7"' angeflanscht und steht mit einem an der Eingangswelle des Winkelgetriebes 56 vorgesehenen Zahnrad 58 mit der Verzahnung des Zahnkranzes 28 in Eingriff. Dort, wo an einer Arbeitsposition 3 keine Basis 50 mit dem von der Welle 54 gebildeten Steuerantrieb notwendig ist, ist die Öffnung 57 durch einen nicht dargestellten Deckel verschlossen.

Die beschriebene Ausbildung der Arbeitsstation 4 hat erhebliche Vorteile. Zum einen kann für unterschiedliche Funktionen dieser Arbeitsstationen stets die gleiche Basis 50 verwendet werden, auf der dann das der Arbeitsstation stärker angepaßte Funktionsteil 53 montiert wird. jede Arbeitsstation 4 ist auswechselbar und kann insbesondere auch bezüglich des Steuerantriebs (Welle 54) außerhalb des Fertigungsautomaten 1 getestet, justiert und/oder repariert werden. Durch den mechanischen Antrieb über das Winkelgetriebe 56, die Gelenkwelle 55 und die Welle 54 ist eine Steuerung der Funktionselemente des Funktionsteiles 53 synchron mit dem Betrieb des Fertigungsautomaten 1 möglich, und zwar verzögerungsfrei, so daß hohe Leistungen möglich sind.

Durch das Anflanschen des Winkelgetriebes an dem horizontalen Absatz 7"' ist eine einfache Montage des jeweiligen Winkelgetriebes gewährleistet. Weiterhin ist es möglich, das jeweilige Winkelgetriebe 56 um die Achse der horizontalen Eingangswelle, auf der das Zahnrad 58 vorgesehen ist, zu drehen, so daß hierdurch auch eine Änderung der Lage bzw. Orientierung der Welle 54 in der horizontalen Ebene möglich ist, und zwar beispielsweise für eine schräge bzw. nicht radiale Anordnung dieser Welle und damit der Arbeitsstation 4 in bezug auf die Achse V, sofern dies in speziellen Fällen erforderlich ist. Durch die Gelenkwelle 55 werden Toleranzen in der Ausrichtung zwischen der Ausgangswelle des Winkelgetriebes 56 und der Welle 54 ausgeglichen. Das Anflanschen des Winkelgetriebes 56 an dem horizontalen Absatz 7"' ist die Höhenlage der Ausgangswelle des Winkelgetriebes genau definiert und damit an die Höhenlage der Welle 54 angepaßt. Mit der Basis 50 ist die Arbeitsstation 4 bzw. deren Funktionsteil 53 in allen drei Raumachsen einstellbar. Die Gelenkwelle 55 ist vorzugsweise als Gelenk- oder Kardanwelle mit Teleskop und mit Kreuzgelenken an beiden Enden ausgebildet, so daß nach dem Anflanschen des jeweiligen Winkelgetriebes 56 ein Einstellen der Arbeitsstation 4 in allen drei Raumachsen möglich ist.

### Hubeinrichtung 5

Die Hubeinrichtung 5 besteht jeweils aus einer Basisplatte 60, die an der Oberseite des Tischelementes 14 befestigt ist und an der zwei vertikale Führungsstangen 61 und 62 mit ihrem unteren Ende gehalten sind. Diese Führungsstangen liegen mit ihren Achsen in einer Ebene, die auch die Achse V einschließt, d.h. die Führungsstange 61 ist bezogen auf die Achse V radial weiter außenliegend als die Führungsstange 62. An den beiden Führungsstangen 61 und 62 ist ein Klotz oder Schlitten 63 in vertikaler Richtung verschiebbar geführt. An dem Schlitten 63 ist ein Schlitten 64 in horizontaler Richtung und radial zur Achse V geführt. Letzterer besitzt an seinem radialen außenliegenden Ende den Träger 6.

Die oberen Enden der Führungsstangen 61 und 62 sind an einer Tragplatte 65 befestigt, die über einen Haltearm 66 fest mit der Tragplatte 17 verschraubt ist. An der Tragplatte 65 ist ein abgewinkelter Steuerhebel 67 befestigt, der mit seinem einen Ende gegen die Unterseite des Randes der oberen Steuerscheibe 21 anliegt und mit seinem anderen Ende in eine vertikale Führung des Schlittens 64 eingreift, und zwar derart, daß eine vertikale Bewegung der Schlittenanordnung 63/64 ohne ein Schwenken des Steuerhebels 67 keine horizontale Bewegung des Schlittens 64 bewirkt. Mit 68 ist eine Feder bezeichnet, die zwischen dem einen Ende des Steuerhebels 67 und der Steuerscheibe 21 wirkt und dieses Ende bzw. ein an diesem Ende vorgesehene Kurvenrolle gegen die Unterseite der Steuerscheibe 21 andrückt. Durch Heben und Senken der Steuerscheibe 21 wird der Hebel 67 geschwenkt, so daß dann der Schlitten 64 die horizontale Hubbewegung (Doppelpfeil A) ausübt.

An der Basis 60 ist ein zweiter Steuerhebel 69 in seiner Mitte schwenkbar vorgesehen, der mit einem Ende in die Umfangsnut 22' der Steuerscheibe 22 eingreift und mit seinem anderen Ende gegen die Unterseite des Schlittens 63 anliegt. Durch Absenken der Steuerscheibe 22 wird somit der Schlitten 63 und damit auch der Schlitten 64 in vertikaler Richtung angehoben. Umgekehrt wird durch Anheben der Steuerscheibe 22 der Schlitten 63 abgesenkt.

Der Steuerhebel 69 besitzt mehrere Bohrungen, die in Längsrichtung dieses Hebels gegeneinander versetzt sind. Weiterhin sind auch in einem Lagerelement 70, welches für den Steuerhebel 69 an der Basis 60 vorgesehen ist, mehrere Bohrungen vorgesehen, so daß die Lage des Gelenkpunktes 71 des Steuerhebels 69 einstellbar ist, und zwar für eine unterschiedliche Übersetzung des Steuerhebels 69 und damit für einen unterschiedlichen Hub des Schlittens 63 bei für alle Arbeitspositionen 3 gleichem Hub der Steuerscheibe 22.

Ebenso wie das Übersetzungsverhältnis des Steuerhebels 69 ist auch das Übersetzungsverhältnis des Steuerhebels einstellbar, und zwar beispielsweise durch Verwendung unterschiedlicher Steuerhebel 67 zum Anpassen des horizontalen Hubes des Schlittens 64 an die jeweiligen Erfordernisse der jeweiligen Arbeitsposition 3 bzw. Arbeitsstation 4.

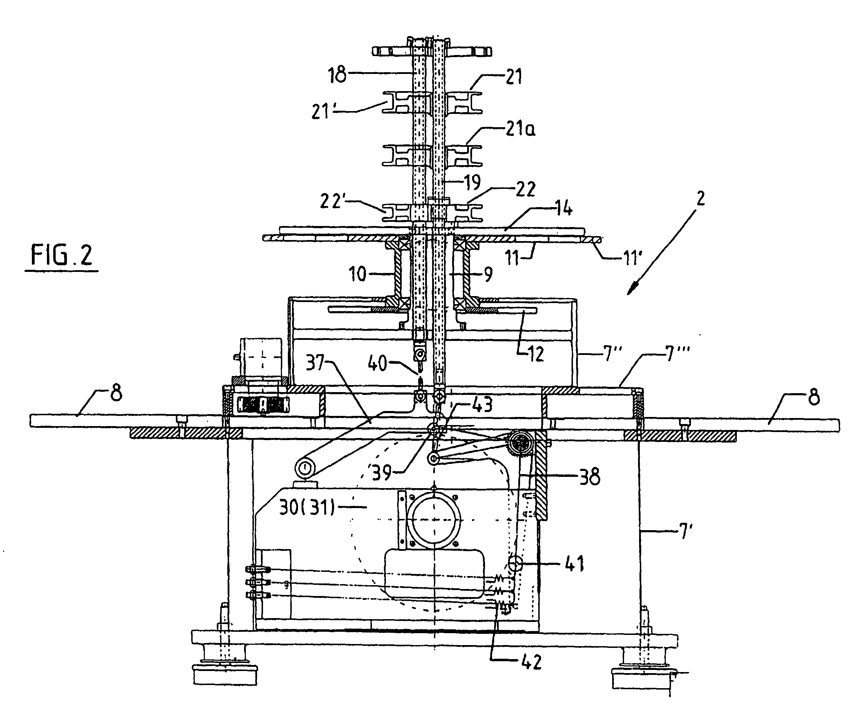

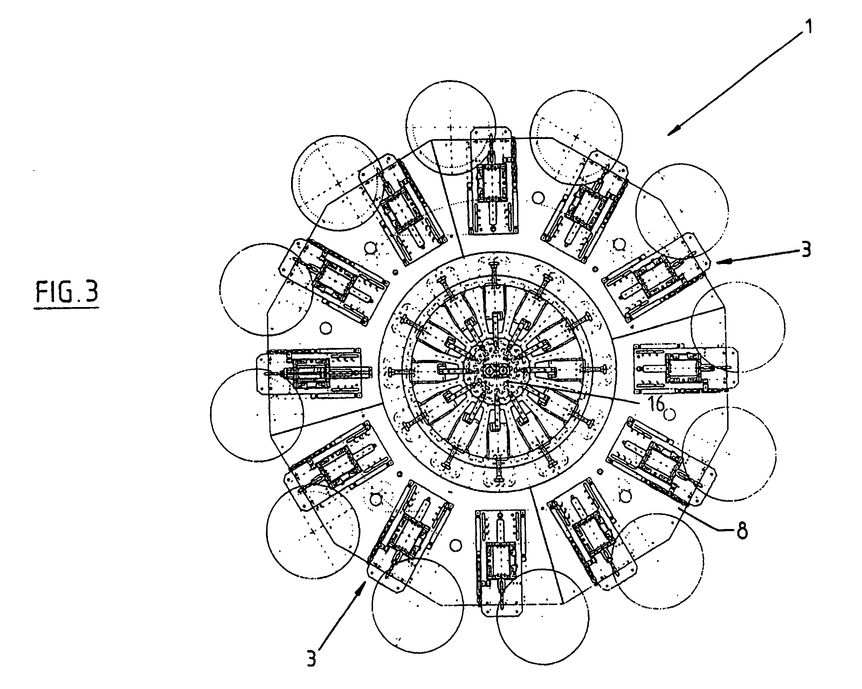

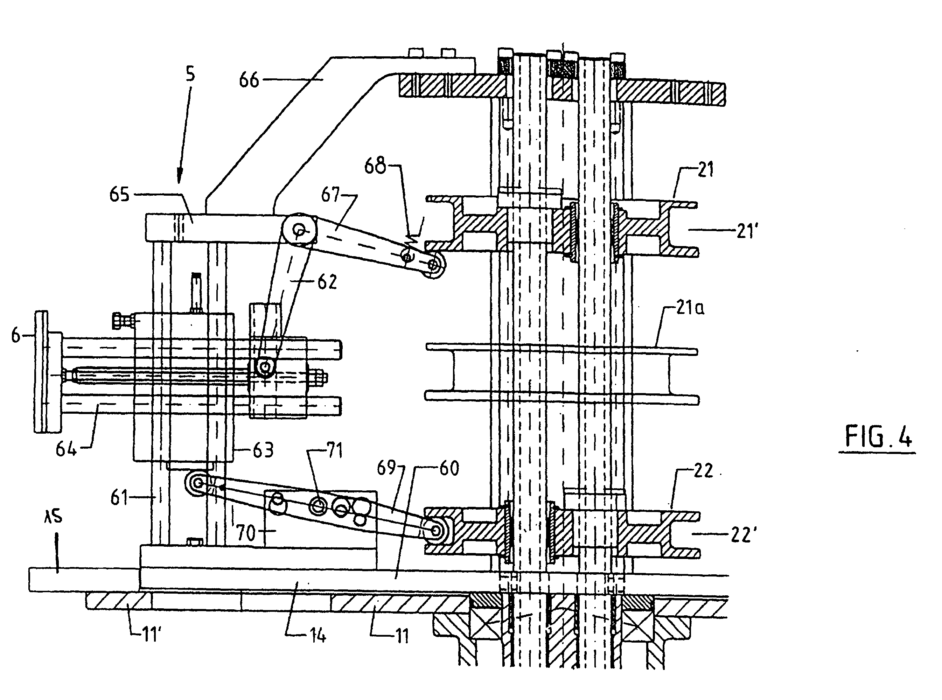

Wie in den Figuren 1 - 4 angedeutet ist, können auch mehr als zwei Steuerscheiben, beispielsweise drei Steuerscheiben 21, 22 und 21a in vertikaler Richtung übereinander vorgesehen sein, wobei dann wiederum für jede Steuerscheibe eine eigene Hubstange vorgesehen ist.

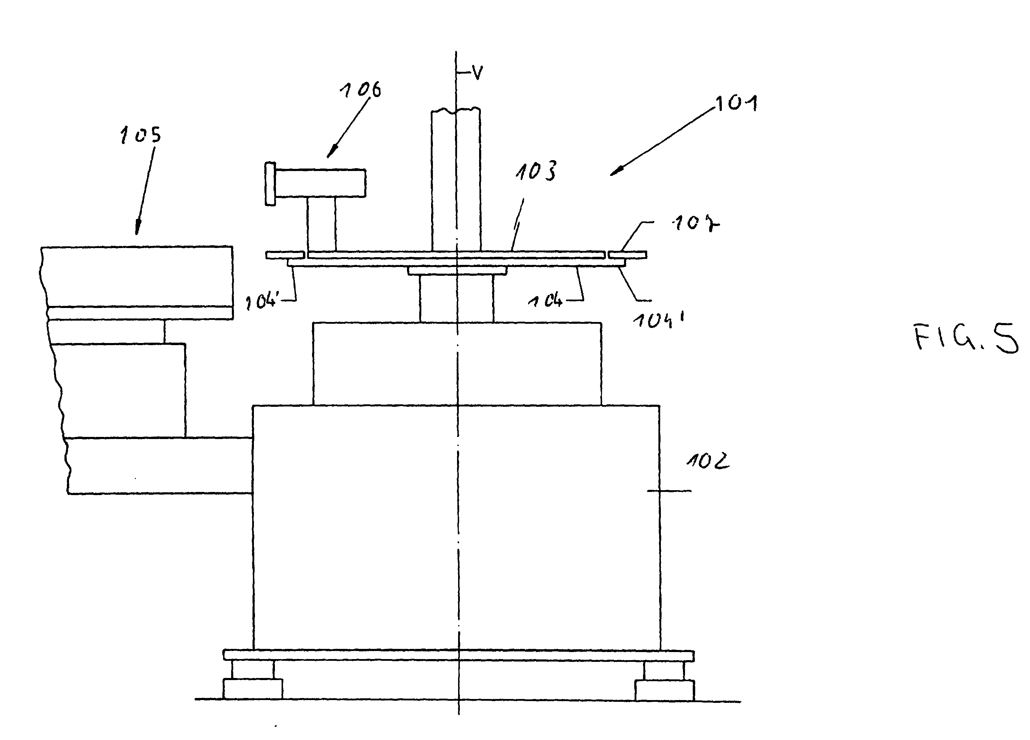

Die in der Fig. 5 dargestellte Grundeinheit ist Bestandteil eines ansonsten nicht näher dargestellten Montageautomaten 101 und besteht im wesentlichen aus einem Vorrichtungsgestell 102, an dessen Oberseite an einer achsgleich mit einer vertikalen Maschinenachse V vorgesehenen Säule ein horizontales, nicht drehendes kreisscheibenförmiges Tischelement 103 vorgesehen ist. Unter diesem Tischelement 103 ist ein ebenfalls kreisscheibenförmiges Tischelement 104 angeordnet, welches um die horizontale Achse V drehbar ist und mit einem Umfangsbereich 104' über den Umfang des Tischelementes 103 vorsteht. Durch einen nicht dargestellten Antrieb ist das Tischelement 104 um die Achse V getaktet angetrieben.

An dem Vorrichtungsgestell sind außen Zuführeinrichtungen und andere ArbeitsStationen 105 verteilt um die Achse V vorgesehen. Am Tischelement 103 sind weitere Funktionselemente 106, beispielsweise Greifer usw. befestigt. Die Funktionselemente 106 sind dann beispielsweise jeweils einer Station 105 zugeordnet.

Am Umfangsbereich 104' des Tischelementes 104 sind in gleichmäßigen Winkelabständen um die Achse V verteilt über diesen Umfangsbereich 104' wegstehende Aufnahmen 107 befestigt, die bei der dargestellten Ausführungsform jeweils von einer im wesentlichen rechteckförmigen Platte 108 gebildet sind, welche mit ihren Oberflächenseiten in einer horizontalen Ebene, d.h. in einer Ebene senkrecht zur Achse V liegt und mit ihrer längeren Mittelachse radial zu der Achse V angeordnet ist. Die Oberseite jeder Platte 108 liegt in einer Ebene mit der Oberseite des Tischelementes 103. An ihrem über den Umfangsbereich 104' wegstehenden Teil bilden die Platten 108 an der Oberseite "Nester" 109, die jewils zur Aufnahme eines Bauteils oder einer Baugruppe dienen, welches bzw. welche in dem Montageautomaten zu einem fertigen Produkt montiert werden, und zwar dadurch, daß diese Nester 109 getaktet an den Stationen 105 vorbei bewegt werden und an jeder Station ein weiterer Montage- und/oder Prüfschritt an dem in einem Nest 109 angeordneten Bauelement vorgenommen wird, so daß mit dem getakteten Weiterbewegen jeder Aufnahme 107 die dort vorhandene Baueinheit zunehmend zu dem fertigen Produkt vervollständigt wird.

Die Besonderheit der dargestellten Grundeinheit 101 besteht darin, daß die Aufnahmen 107 gesteckt und damit austauschbar an dem drehenden Tischelement 104 vorgesehen sind. Hierfür sind am Umfangsbereich 104' oben in gleichmäßigen Winkelabständen um die Achse V verteilt Halter 110 vorgesehen, die zwischen sich Halterungen 110' bilden und bei der dargestellten Ausführungsform im wesentlichen als rechteckförmige Platten ausgeführt sind. Diese sind mit ihrer Längserstreckung tangential zu einer gedachten Kreislinie um die Achse V angeordnet. Jeder Halter 110 ist im Bereich seiner schmäleren Umfangsseiten jeweils mit einer Ausnehmung oder Ausfräsung 111 bzw. 112 derart versehen, daß die an der Oberseite im wesentlichen rechteckförmigen Halter 110 an ihrer Unterseite trapezförmig ausgebildet sind, und zwar mit zwei im wesentlichen parallelen Trapezseiten 113 und 114 sowie mit zwei schrägen Trapezseiten 115 und 116. Von diesen ist die Trapezseite 113 bei am Tischelement 104 befestigtem Halter 110 bezogen auf die Achse V radial innen und die Trapezseite 114 radial außen liegend angeordnet, und zwar jeweils tangential zu einer gedachten, die Achse V umschließenden Kreislinie. Die beiden schrägen Trapezseiten 115 und 116, die jeweils von einer Ausnehmung 111 bzw. 112 gebildet sind, bilden jeweils ebene Flächen, die senkrecht zu der Ober- und Unterseite des plattenförmigen Halters 111 liegt und bei am Tischelement 104 montierten Halter 110 senkrecht zur Ebene dieses Tischelementes angeordnet sind. Die Ebenen der Trapezseiten 115 und 116 schließen jeweils mit der Ebene der benachbarten Schmalseite des plattenförmigen Halters 110 einen spitzen Winkel α ein, der sich bei montiertem Halter 110 zur Achse V der Grundeinheit 101 hin öffnet und beispielsweise 6° - 10° beträgt.

Die Ausnehmungen 111 und 112 sind weiterhin so geformt, daß der Halter 110 an der Oberseite jeweils einen über die Trapezfläche 115 bzw. 116 überstehenden Plattenabschnitt 117 bzw. 118 bildet. In jedem Halter 110 ist ein bolzenartiges Rastelement 119 gegen die Wirkung einer Druckfeder 120 in Längsrichtung verschiebbar vorgesehen, und zwar in einer Ausnehmung 121 und in einer Achsrichtung L, die parallel zu den Ebenen der Oberflächenseiten des Halters 110 liegt und mit der radial innenliegenden Längs- oder Trapezseite 113 bzw. deren gedachten Verlängerung einen spitzen Winkel β, d.h. einen Winkel wesentlich kleiner als 45° einschließt, der sich zu der Trapezseite 115 hin öffnet. An der Trapezseite 116 ist die Ausnehmung 121 offen. Weiterhin ist die Ausbildung so getroffen, daß das Rastelement 119 mit einem spitz zulaufenden Ende 119' über die von der Trapezseite 116' gebildete Fläche vorsteht.

Im montierten Zustand befindet sich jede Aufnahme 107 bzw. deren Platte 108 in der Halterung 110' zwischen zwei am Umfangsbereich 104' aufeinanderfolgenden Haltern 110, die derart voneinander beabstandet vorgesehen sind, daß die jeweilige Platte 108 mit einer Längsseite 108', die eben ausgebildet ist, gegen die ebene Fläche bzw. Trapezseite 115 eines Halters 110 anliegt. Die andere Längsseite 108" der Platte 108 ist der Trapezseite 116 eines benachbarten Halters 110 benachbart. Das an diesem benachbarten Halter 110 vorgesehene Rastelement 119 greift mit seinem Ende 119' in eine Rastvertiefung 122 an der Längsseite 10 8" ein. Durch die Feder 120 ist weiterhin die jeweilige Aufnahme bzw. Platte 108 mit ihrer Längsseite 108' gegen die Trapezseite 115 dicht anliegend angedrückt.

Durch die überstehenden Abschnitte 117 und 118, die die jeweilige Platte 108 an ihrer Oberseite übergreifen, ist diese Platte an beiden Längsseiten 108' und 108" in den taschenartigen Ausnehmungen 111 und 112 formschlüssig gehalten.

Jede Platte 108 besitzt weiterhin an der Längsseite 108' einen Stift 123, der bei jeder vollständig in die Halterung 110' eingeschobener Platte 108 gegen die außenliegende Längsseite eines Halters 110 anliegt. Mit dem jeweiligen Stift 123 und mit der gegen die Trapezseite 115 des gleichen Halters 110 anliegenden Längsseite 108' ist jede 107 in bezug auf diesen in der Fig. 6 jeweils links von jeder Aufnahme 107 vorgesehenen Halter 110 exakt orientiert bzw. justiert, so daß bei exakter Montage der Halter 110 am Umfangsbereich 104' auch die Aufnahmen 104 nach dem Einstecken in die taschenartigen Halterungen 110' exakt positioniert sind.

Für die Befestigung bzw. Fixierung der Halter 110 am Umfangsbereich 104' wird ein Werkzeug 124 verwendet, welches hinsichtlich seiner Formgebung einer Platte 108 entspricht, aber mit Hilfe eines Fixierelementes 125 am festen Tischelement 103 befestigt bzw. fixiert ist, und zwar derart, daß eine der Längsseite 108' entsprechende Längsseite 124' des Werkzeuges 124 exakt die Orientierung aufweist, die diese Längsseite 108' bzw. die Trapezseite 115 des zu befestigenden Halters 110 besitzen sollen.

Zur Befestigung eines Halters 10 wird dieser mit seiner Trapezseite 115 an der Längsseite 124' des Werkzeuges 124 anliegend auf den Umfangsbereich 104' aufgesetzt, und zwar derart, daß die außenliegende Längsseite bzw. Trapezseite 114 des Halters 110 gegen den am Werkzeug 124 ebenfalls vorgesehenen Stift 123 anliegt. Anschließend wird der plattenförmige Halter durch Anschrauben mit dem Umfangsbereich 104' verbunden und dann ggf. in der genauen Position verstiftet.

Das Tischelement 104 wird dann um eine Teilung weitergedreht, und zwar in der Weise, daß sich der zuvor befestigte Halter 110 von der Anlagefläche 124' wegbewegt, womit das Werkzeug 124 am Tischelement 103 verbleiben kann. Durch Anlegen eines weiteren Halters 110 mit seiner Trapezseite 115 gegen die Anlagefläche 124' kann auch dieser Halter in der vorstehend beschriebenen Weise exakt positioniert werden. Der Abstand zwischen zwei Haltern 110 wird beispielsweise durch Verwendung einer Aufnahme 107 eingestellt. Die Halter 110 sind auch an der Unterseite der überstehenden Abschnitte 117 und 118 mit geringen Toleranzen gearbeitet, so daß durch die Unterseite der überstehenden Abschnitte 117 und 118, gegen die die Oberseite der jeweiligen Aufnahme 107 anliegt, eine genaue Positionierung in der Höhe gegeben ist. Zum Ausgleich von Toleranzen in der Dicke der Platten 108 sind zwischen der Oberseite des Umfangsbereich 104' und der Unterseite der jeweiligen Platte 108 Ausgleichsplatten 126 vorgesehen.

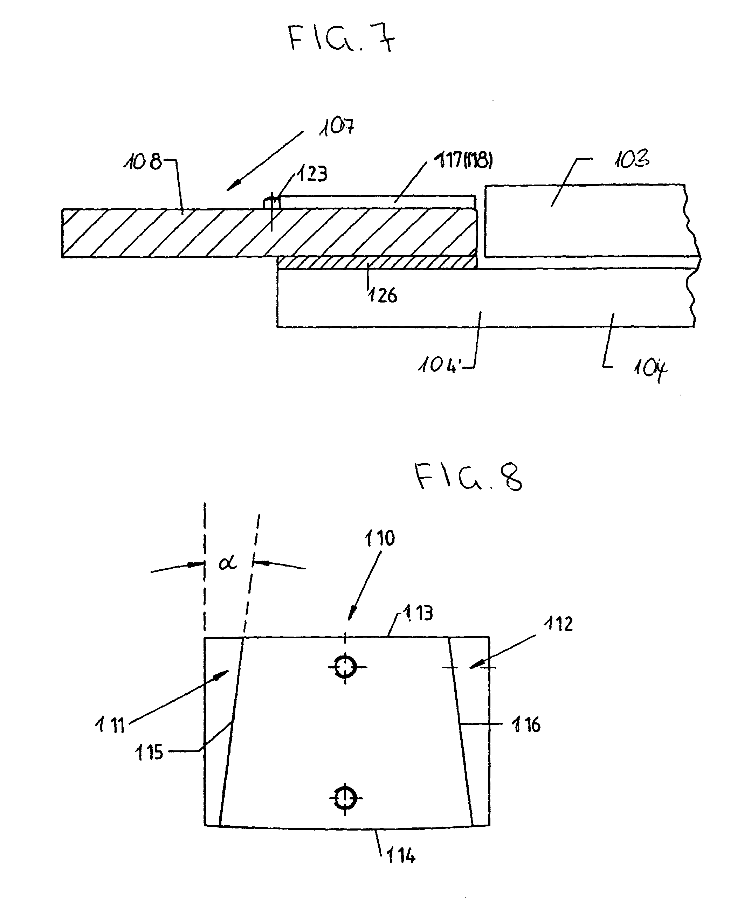

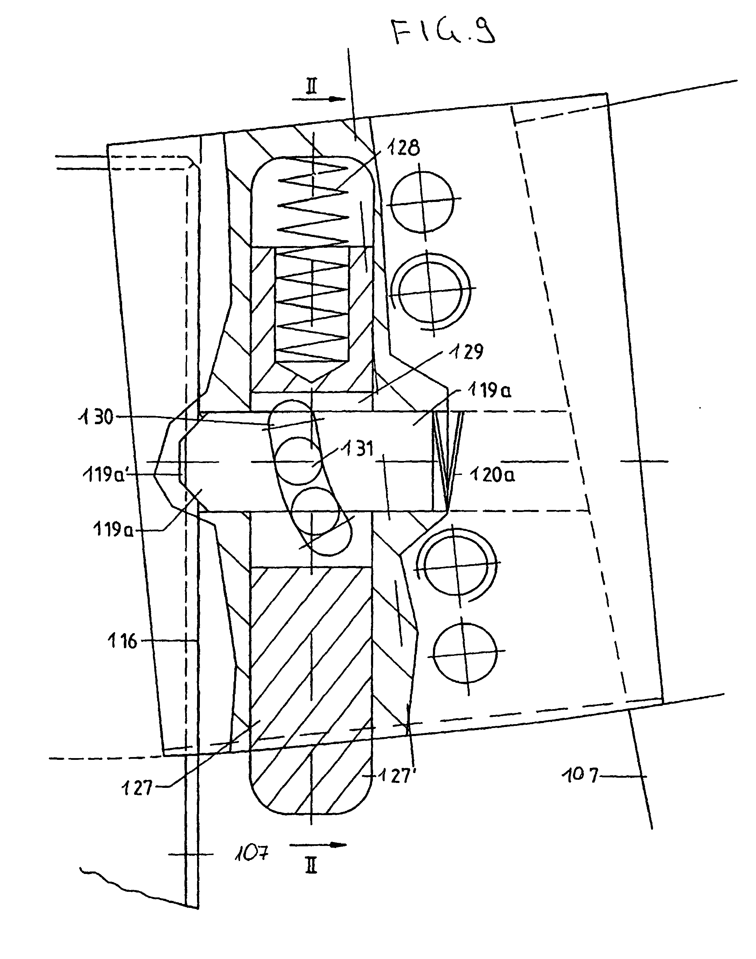

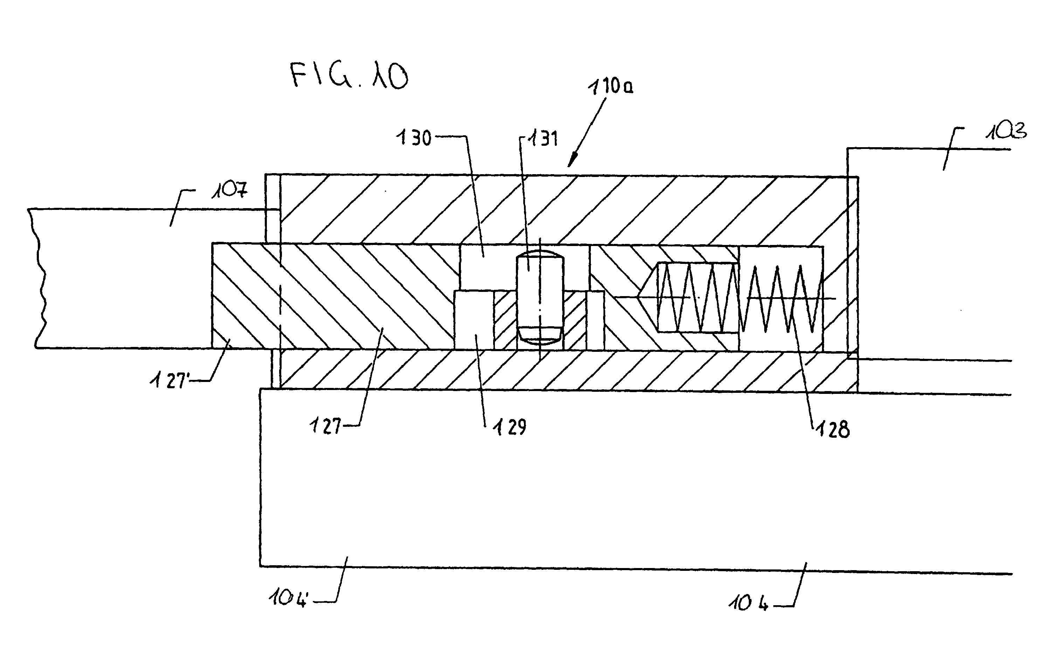

Die Figuren 9 und 10 zeigen einen Halter 110a, der in seiner grundsätzlichen Ausbildung und Funktion dem Halter 110 entspricht und wiederum ein unter der Wirkung der Druckfeder 120a stehende Rastelement 119a aufweist, welches zum rastenden Fixieren der jeweiligen Aufnahme 107 dient, wie dies vorstehend für das Rastelement 119 des Halters 110 beschrieben wurde.

Die Besonderheit des Halters 110a besteht darin, daß in diesem in einer Achsrichtung senkrecht zur Bewegungsrichtung des Rastelementes 119a ein Betätigungs- und Sperrsschieber 127 verschiebbar vorgesehen ist, und zwar gegen die Wirkung der Druckfeder 128 aus einer nicht betätigten Stellung, in der sich das Rastelement 119a in seiner die Aufnahme 107 fixierenden Stellung befindet, und einer betätigten Stellung, in der das Rastelement 119a durch den Betätigungsschieber 127 aus der fixierenden Stellung (beispielsweise zur Freigabe der Aufnahme 107) zurückbewegt ist. Der Betätigungsschieber 127 steht mit einem Ende 127' über die Vorderseite des Halters 110a und damit bei am Tischelement 104 montiertem Halter auch über den Außenumfang dieses Tischelementes vor, so daß er gegen die Wirkung der Druckfeder 128 in Bezug auf die Achse des Tischelementes 104 im wesentlichen radial nach innen gedrückt werden kann.

Der Betätigungsschieber 127 besitzt an einer Seite eine Ausnehmung 129, die von dem Rastelement 119a durchgriffen wird. Die Abmessung der Ausnehmung 129a in Achsrichtung des Betätigungsschiebers 127 legt den maximalen Hub für diesen Betätigungsschieber fest.

Im Bereich der Ausnehmung 129 besitzt der Betätigungsschieber 127 weiterhin eine Steuerkurve 130, die von einer entsprechenden Öffnung im Boden der Ausnehmung 129 gebildet ist. In die Steuerkurve 130 greift ein am Rastelement 119a vorgesehener Führungsbolzen 131. Der Verlauf der Steuerkurve 130 für den in diese eingreifenden Führungsbolzen 131 ist dabei so gewählt, daß dann, wenn sich der Betätigungsschieber 127 in seiner nicht gedrückten Stellung befindet, sich das Rastelement 119a in seiner rastenden oder fixierenden Stellung befindet und in dieser auch so verriegelt ist, daß ein unerwünschtes Lösen der durch das jeweilige Rastelement 119a gehaltenen Aufnahme 107 nicht möglich ist. Durch Drücken des Betätigungsschiebers 127, d.h. durch Verschieben dieses Betätigungsschiebers gegen die Druckfeder 128 radial oder in etwa radial zur Achse des Tischelementes 104 nach innen wird die Rastverbindung zwischen dem Rastelement 119a und der mit diesem gehaltenen Aufnahme 107 gelöst.

Für die vorgenannten Funktionen verläuft die Steuerkurve 130 insgesamt derart, daß sie mit der Längsachse des Betätigungsschiebers 127 einen Winkel wesentlich kleiner als 45° einschließt, der sich zu der der Achse des Tischelementes 104 abgewandten Seite hin öffnet. Das innere, d.h. der Feder 128 benachbarte Ende der Steuerkurve 130 liegt weiterhin der Seite 116a des Halters 110a, über die (Seite) das Rastelement 119a vorsteht, näher als das andere Ende der Steuerkurve 130. Der Winkel, den die Steuerkurve 130 mit der Achse des Betätigungsschiebers 127 einschließt, ist wesentlich kleiner als 45°, so daß ein Druck auf das Ende 119a' ein Verschieben des Betätigungsschiebers 127 über den Führungsbolzen 131 und die Steuerkurve 130 nicht bewirken kann.

Die Halter 110, 110a und Aufnahmen 107 bestehen ebenso wie die Tischelemente 103 und 104 vorzugsweise aus Metall.

### Bezugszeichenliste

- 1: Fertigungsautomat
- 2: Grundeinheit
- 3: Arbeitsposition
- 4: Arbeitsstation
- 5: Hubeinrichtung
- 6: Träger
- 7: Maschinengestell
- 7', 7": Abschnitt
- 7''': Absatz
- 8: Tisch
- 9: Säule
- 10: Hohlwelle
- 11: Tischelement
- 11': Umfangsbereich
- 12: Antrieb
- 13: Exzenter- oder Malteserantrieb
- 14: Tischelement
- 15: Aufnahme
- 16: Stange
- 17: Tragplatte
- 18, 19: Hubstange
- 20: Platine
- 21, 21a, 22: Steuerscheibe
- 21', 22': Umfangsnut
- 23: Winkelgetriebe
- 24: Welle
- 25: Getriebeanordnung
- 26: Welle
- 27: Ritzel
- 28: Zahnkranz
- 29: Träger
- 30, 31: Kurvenscheibe
- 32: Getriebe
- 33: Welle
- 34: Sicherheitskupplung
- 34': Kupplungsteil
- 35: Sensor
- 36: Magnetbremse
- 37, 38: Schwinge
- 39: Kurvenrolle
- 40: Zwischenhebel
- 41: Kurvenrolle
- 42: Feder
- 43: Zwischenhebel
- 50: Basis oder Block
- 51: Aufspannplatte
- 52: Träger
- 53: Funktionsteil
- 54: Welle
- 55: Gelenkwelle
- 56: Winkelgetriebe
- 57: Öffnung
- 58: Zahnrad
- 101: Grundeinheit
- 102: Vorrichtungsgestell
- 103: Tischelement
- 104: Tischelement
- 104': Umfangsbereich
- 105: Arbeitsstation
- 106: Funktionselement
- 107: Aufnahme
- 108: Platte
- 108', 108": Längsseite
- 109: Nest
- 110, 110a: Halter
- 110': Halterung/ Haltebereich
- 111, 112: Ausnehmung
- 113-116, 116a: Trapezseite
- 117, 118: Abschnitt
- 119, 119a: Rastelement
- 120: Druckfeder
- 121: Ausnehmung
- 122: Rastvertiefung
- 123: Stift
- 124: Justierwerkzeug
- 124': Anlagefläche
- 125: Fixierelement
- 126: Ausgleichsplatte
- 127: Betätigungsschieber
- 127': Ende
- 128: Druckfeder
- 129: Ausnehmung
- 130: Steuerkurve
- 131: Führungsbolzen

## Patentansprüche

1. Fertigungs- oder Montageautomat mit einem um eine vertikale Maschinenachse (V) drehbaren Rotor (11) und mit mehreren am Umfang des Rotors vorgesehenen Aufnahmen (15) für Bauelemente oder Baugruppen, mit einem zentralen Antrieb für den Rotor (11), um die Aufnahmen (15) getaktet von Arbeitsposition zu Arbeitsposition zu bewegen, mit ersten Funktionselementen (5) jeweils an einer Arbeitsposition, und mit einer für mehrere erste Funktionselemente (5) gemeinsamen Steuereinrichtung, die von dem zentralen Antrieb angetrieben ist und synchron mit der getakteten Drehbewegung des Rotors (11) gesteuerte Bewegungen der ersten Funktionselemente um und/oder in wenigstens einer Achsrichtung (A, B) die bewirkt, **dadurch gekennzeichnet, daß** die gemeinsamen Steuereinrichtung für sämtliche erste Funktionselemente (5) wenigstens ein gemeinsames tellerartiges Hubelement (21, 22) aufweist, welches eine Steuerfläche bildet, mit der Steuerelemente (67, 69) sämtlicher erster Funktionselemente zur Erzeugung der Bewegung um die bzw. in der wenigstens einen Achse (A, B) zusammenwirken, daß die Steuerscheibe (21) für einen Hub in Richtung der Maschinenachse (V) an einer Hub- oder Zugstange (18, 19) vorgesehen ist, die mit ihrer Achse parallel zur Maschinenachse (V), gegenüber dieser radial versetzt und in einem zentralen Teil des Maschinengestells (7) geführt ist.

2. Fertigungsautomat nach nach Anspruch 1 oder 2, **dadurch gekennzeichnet, daß** am Maschinengestell (7) ein Hilfsantrieb (28) zum Ankoppeln von Steuerantrieben (54, 55, 56) für die Arbeitsstationen (4) vorgesehen sind.

3. Fertigungsautomat nach einem der vorhergehenden Ansprüche, **dadurch gekennzeichnet, daß** im Antriebsstrang zwischen einem den Rotor (11) antreibenden Motor und diesem Rotor (11) eine Sicherheitskupplung (34) vorgesehen ist, die bei Überschreiten eines vorgegebenen Drehmomentes den Antriebsstrang durch Ausrasten trennt, und daß im Antriebsstrang nach der Sicherheitskupplung (34) eine Bremse (36) vorgesehen ist, die bei ausgerasteter Sicherheitskupplung (34) den Rotor (11) blockiert.

4. Fertigungsautomat nach einem der vorhergehenden Ansprüche, **dadurch gekennzeichnet, daß** die wenigstens eine Steuerscheibe (21, 22) gleitend an weiteren, parallel zu ihrer Hubstange (18, 19) angeordneten Stangen (19, 18, 16) geführt ist.

5. Fertigungsautomat nach einem der vorhergehenden Ansprüche, **dadurch gekennzeichnet, daß** wenigstens zwei Steuerscheiben (21, 22) in Richtung der Maschinenachse (V) übereinander oder gegeneinander versetzt vorgesehen sind, daß jeder Steuerscheibe (21, 22) eine eigene Hubstange (18, 19) zugeordnet ist, an der die zugehörige Steuerscheibe axial nicht verschiebbar befestigt ist, und daß die erste Steuerscheibe (21) auf der Hubstange (19) der zweiten Steuerscheibe und die zweite Steuerscheibe (22) auf der Hubstange (18) der ersten Steuerscheibe (21) axial verschiebbar angeordnet ist.

6. Fertigungsautomat nach einem der vorhergehenden Ansprüche, **dadurch gekennzeichnet, daß** um die Maschinenachse (V) verteilt Führungsstangen (16) vorgesehen sind, die mit ihren Achsen parallel zur Maschinenachse (V) und gegenüber dieser radial vesetzt angeordnet sind, und daß die Steuerscheiben (21, 22) auf diesen Führungsstangen (16) verschiebbar geführt sind.

7. Fertigungsautomat nach einem der vorhergehenden Ansprüche, **dadurch gekennzeichnet, daß** jedes erste Funktionselement einen Träger (6) aufweist, an welchem ein Werkzeug, beispielsweise ein Einleger, eine Zange dergl. befestigbar ist, daß der Träger an einem in einer ersten Achsrichtung (A) beweglichen Schritten (64) vorgesehen ist, daß der Schlitten (64) an einem Hilfs-Schlitten (63) angeordnet ist, der in einer zweiten Achsrichtung (B) beweglich ist, und daß jedes erste Funktionselement (5) eine erste Steuereinrichtung (67) zum Bewegen des Schlittens (64) in der ersten Achsrichtung (A) sowie ein zweites Steuerelement (69) zum Bewegen des Schlittens (64) in der zweiten Achsrichtung (B) aufweist.

8. Fertigungsautomat nach einem der vorhergehenden Ansprüche, **dadurch gekennzeichnet, daß** die Steuerelemente Steuerhebel (67, 69) sind.

9. Fertigungsautomat nach einem der vorhergehenden Ansprüche, **dadurch gekennzeichnet, daß** die Übersetzung jedes Steuerelementes (67, 69) einstellbar ist.

10. Fertigungsautomat nach einem der vorhergehenden Ansprüche, **dadurch gekennzeichnet, daß** mehr als zwei Hubstangen (18, 19) vorgesehen sind, und daß an jeder Hubstange eine Steuerscheibe (21, 22) befestigt ist.

11. Fertigungsautomat nach einem der vorhergehenden Ansprüche, **dadurch gekennzeichnet, daß** sämtliche Hubstangen durch sämtliche Steuerscheiben (21, 22) hindurchgeführt sind.

12. Fertigungsautomat nach einem der vorhergehenden Ansprüche, **dadurch gekennzeichnet, daß** die ersten Funktionselemente (5) Hubeinrichtungen sind.

13. Fertigungsautomat nach einem der vorhergehenden Ansprüche, **gekennzeichnet durch** am Maschinengestell des Fertigungsautomaten vorgesehene Arbeitsstationen (4), die jeweils auf einem für sämtliche Arbeitsstationen gleichen Basis (50) an die jeweilige Arbeitsstation angepaßte zweite Funktionselemente (53) aufweisen.

14. Fertigungsautomat nach einem der vorhergehenden Ansprüche, **dadurch gekennzeichnet, daß** die zweiten Funktionseinheiten (53) Zuführungen sind.

15. Fertigungsautomat nach einem der vorhergehenden Ansprüche, **dadurch gekennzeichnet, daß** der Hilfsantrieb von einem um die Maschinenachse (V) umlaufend angetriebenen Zahnrad oder Zahnkranz (28) gebildet ist, und daß die Steuerantriebe jeweils ein Winkelgetriebe (56) mit einem mit dem Zahnrad oder Zahnkranz in Eingriff bringbaren Zahnrad (58) am Eingang und mit wenigstens einer Welle (54, 55) am Ausgang ausgebildet ist.

16. Fertigungsautomat nach einem der vorhergehenden Ansprüche, **dadurch gekennzeichnet, daß** das Winkelgetriebe (54) an einer Öffnung (57) an einem gehäuseartigen Maschinengestell (7) anflanschbar ist.

17. Fertigungsautomat nach einem der vorhergehenden Ansprüche, **dadurch gekennzeichnet, daß** das Winkelgetriebe (57) an einer horizontalen oder im wesentlichen horizontalen Fläche (7''') des Maschinengestells (7) anflanschbar ist.

18. Fertigungsautomat nach einem der vorhergehenden Ansprüche, **dadurch gekennzeichnet, daß** im Antriebsstrang zwischen einem den Rotor (11) antreibenden Motor und dem Rotor (11) ein Malteser-Antrieb (12, 13) vorgesehen ist.

19. Fertigungsautomat nach einem der vorhergehenden Ansprüche, **dadurch gekennzeichnet, daß** im Antriebsstrang zwischen einem den Rotor (11) antreibenden Motor und diesem Rotor (11) ein austauschbares Getriebe (32) zur Realisierung unterschiedlicher Bewegungs- und Stillstandzeiten.

20. Fertigungsautomat nach einem der vorhergehenden Ansprüche, **dadurch gekennzeichnet, daß** die Arbeitsstation (5) jeweils aus einer standardisierten Basis (50) und aus auf dieser Basis montierten Funktionseinheit (53) bestehen.

21. Fertigungsautomat nach einem der vorhergehenden Ansprüche, **dadurch gekennzeichnet, daß** an der Basis eine antreibbare Welle (54) für einen Steuerantrieb der Arbeitsstation (4) vorgesehen ist.

22. Fertigungsautomat nach einem der vorhergehenden Ansprüche, **gekennzeichnet durch** mehrere am Umfang (104') des rotors oder eines drehbaren Tischelementes (104) vorgesehene Aufnahmen (107) für Bauelemente oder Baugruppen, wobei die Aufnahmen (107) über Halterungen (110') am Tischelement (104) derart befestigt sind, daß sie radial zur Achse des Tischelementes (104) steckbar sind.

23. Fertigungsautomat nach Anspruch 22, **dadurch gekennzeichnet, daß** die Halterungen (110') oder diese bildenden Halter (110, 110a) taschenartige Ausnehmungen (111, 112) aufweisen, die die sich mit einer Seite am Tischelement (104) oder den Halterungen (110') abstützenden Aufnahmen (107) an einer gegenüberliegenden Seite formschlüssig übergreifen und die jeweils wenigstens eine erste Anlage (115) für die genaue Orientierung und/oder Positionierung der Aufnahmen (107) am Umfang (104') bilden.

24. Fertigungsautomat nach Anspruch 22, oder 23, **dadurch gekennzeichnet, daß** die Halterungen (110') oder Halter (110, 110a) jeweils wenigstens eine zweite Anlage (114) zur Festlegung des radialen Abstandes der Aufnahmen (107) von der Achse (V) des Tischelementes (104) bilden.

25. Fertigungsautomat nach einem der Ansprüche 22 - 24, **dadurch gekennzeichnet, daß** die Aufnahmen (107) Gegen-Flächen für die Anlagen (115, 114) bilden.

26. Fertigungsautomat nach einem der Ansprüche 22 - 25, **dadurch gekennzeichnet, daß** sämtliche Anlagen für jede Aufnahme (107) jeweils an einem gemeinsamen Halter (110, 110a) vorgesehen sind.

27. Fertigungsautomat nach einem der Ansprüche 22 - 26, **gekennzeichnet durch** wenigstens ein Rastelement (119, 119a) zum rastenden Fixieren der Aufnahme (107) in der von wenigstens einem Halter (110, 110a) gebildeten Halterung.

28. Fertigungsautomat nach Anspruch 27, **gekennzeichnet durch** einen Betätigungsschieber (127) zum Betätigen und Verriegeln des Rastelementes (119a) in der die Aufnahme (107) fixierrenden Stellung.

## Claims

1. Automatic manufacturing or assembly machine with a rotor (11) that can be rotated around a vertical machine axis (V), and with several seatings (15) provided around the circumference of the rotor for construction elements or subassemblies, with a central drive for the rotor (11) in order to move the seatings (15), in a cycled manner, from one working position to another, with first function elements (5) one at each work position, and with a common control device for several first function elements (5) which is driven by the central drive, and [which effects] controlled movements of the first function elements around and/or in at least one axis direction (A, B) synchronously with the cycled rotational movement of the rotor (11),
**characterised in that**
the common control device for all the first function elements (5) has at least one common plate-like lifting element (21, 22) which forms a control surface, with which control elements (67, 69) of all the first function elements interact to create the movement around or in the at least one axis (A, B); that for a stroke in the direction of the machine axis (V), the control disk (21) is provided on a lifting rod or connecting rod (18, 19) which is held with its axis parallel to the machine axis (V), radially offset relative to this, in a central part of the machine frame (7).

2. Automatic manufacturing machine in accordance with claim 1 or 2 [*sic*],
**characterised in that** provided on the machine frame (7) are an auxiliary drive (28) for coupling on control drives (54, 55, 56) for the work stations (4).

3. Automatic manufacturing machine in accordance with one of the preceding claims,
**characterised in that** provided in the drive train between a motor driving the rotor (11) and this rotor [itself] is a safety coupling (34) which, when a given torque is exceeded, separates the drive train by disengaging, and that provided in the drive train after the safety coupling (34) is a brake (36) which blocks the rotor (11) when the safety coupling (34) is disengaged.

4. Automatic manufacturing machine in accordance with one of the preceding claims,
**characterised in that** the at least one control disk (21, 22) is held so as to slide on further rods (19, 18, 16) arranged parallel to its lifting rod (18, 19).

5. Automatic manufacturing machine in accordance with one of the preceding claims,
**characterised in that** at least two control disks (21, 22) are provided, over one another or offset relative to one another, in the direction of the machine axis (V); that each control disk (21, 22) has its own lifting rod (18, 19) assigned to it, on which the corresponding control disk is fixed so as not to be axially movable; and that the first control disk (21, 22) is arranged so as to be axially movable on the lifting rod (19) of the second control disk and the second control disk (22) is arranged so as to be axially movable on the lifting rod (18) of the first control disk (21).

6. Automatic manufacturing machine in accordance with one of the preceding claims,
**characterised in that** distributed around the machine axis (V) are guide rods (16) which are arranged with their axes parallel to the machine axis (V) and are radially offset relative to this, and that the control disks (21, 22) are held on these guide rods (16) such that they can be moved.

7. Automatic manufacturing machine in accordance with one of the preceding claims,
**characterised in that** each first function element has a carrier (6) on which a tool, for example a feeder, pincers or the like can be fixed; that the carrier is provided on a slide (64) that moves in a first axis direction (A); that the slide (64) is arranged on an auxiliary slide (63) which can be moved in a second axis direction (B); and that each first function element (5) has a first control device (67) for moving the slide (64) in the first axis direction (A) as well as a second control element (69) for moving the slide (64) in the second axis direction (B).

8. Automatic manufacturing machine in accordance with one of the preceding claims,
**characterised in that** the control elements are control levers (67, 69).

9. Automatic manufacturing machine in accordance with one of the preceding claims,
**characterised in that** the transmission of each control element (67, 69) can be adjusted.

10. Automatic manufacturing machine in accordance with one of the preceding claims,
**characterised in that** more than two lifting rods (18, 19) are provided, and that affixed to each lifting rod is a control disk (21, 22).

11. Automatic manufacturing machine in accordance with one of the preceding claims,
**characterised in that** all lifting rods are led through all control disks (21, 22).

12. Automatic manufacturing machine in accordance with one of the preceding claims,
**characterised in that** the first function elements (5) are lifting devices.

13. Automatic manufacturing machine in accordance with one of the preceding claims,
**characterised by** work stations (4) which are provided on the machine frame of the automatic manufacturing machine, and which in each case have second function elements (53) that are adapted to the respective work station, on a base (50) that is the same for all work stations.

14. Automatic manufacturing machine in accordance with one of the preceding claims,
**characterised in that** the second function units (53) are feed conduits.

15. Automatic manufacturing machine in accordance with one of the preceding claims,
**characterised in that** the auxiliary drive is formed by a gearwheel or toothed ring (28) driven to revolve around the machine axis (V), and that the control drives are designed in each case as a bevel gear (56) with a gearwheel (58) that can be brought to engage with the gearwheel or toothed ring at the input, and with at least one shaft (54, 55) at the output.

16. Automatic manufacturing machine in accordance with one of the preceding claims,
**characterised in that** the bevel gear (54) can be flange-mounted to an opening (57) on a housing-like machine frame (7).

17. Automatic manufacturing machine in accordance with one of the preceding claims,
**characterised in that** the bevel gear (57) [*sic*] can be flange-mounted to a horizontal or essentially horizontal surface (7"') of the machine frame (7).

18. Automatic manufacturing machine in accordance with one of the preceding claims,
**characterised in that** provided in the drive train between a motor that drives the rotor (11) and the rotor (11) itself is a Geneva drive (12, 13).

19. Automatic manufacturing machine in accordance with one of the preceding claims,
**characterised in that** provided in the drive train between a motor that drives the rotor (11) and this rotor (11) itself is an exchangeable gear (32) for realising different movement and standstill times.

20. Automatic manufacturing machine in accordance with one of the preceding claims,
**characterised in that** the work stations (5) in each case comprise a standardised base (50) and [a] function unit (53) mounted on this base.

21. Automatic manufacturing machine in accordance with one of the preceding claims,
**characterised in that** provided on the base is a drivable shaft (54) for a control drive of the work station (4).

22. Automatic manufacturing machine in accordance with one of the preceding claims,
**characterised by** several seatings (107), provided on the circumference (104') of the rotor or of a rotatable table element (104), for construction elements or subassemblies, wherein the seatings (107) are affixed via mountings (110') on the table element (104) in such a way that they can be plugged in radially to the axis of the table element (104).

23. Automatic manufacturing machine in accordance with claim 22, **characterised in that** the mountings (110'), or holders (110, 110a) that form them, have pocket-like recesses (111, 112) which, in a form-fitting manner, cover the seatings (107) on an opposite side, that support themselves with one side on the table element (104) or the mountings (110'), and which in each case form a first guide (115) for the precise orientation and/or positioning of the seatings (107) on the circumference (104').

24. Automatic manufacturing machine in accordance with claim 22 or 23, **characterised in that** the mountings (110') or holders (110, 1 10a) in each case form at least one second guide (114) for fixing the radial distance of the seatings (107) from the axis (V) of the table element (104).

25. Automatic manufacturing machine in accordance with one of the claims 22 - 24,
**characterised in that** the seatings (107) form opposite surfaces for the guides (115, 114).

26. Automatic manufacturing machine in accordance with one of the claims 22 - 25,
**characterised in that** all guides for each seating (107) are in each case provided on a common holder (110, 110a).

27. Automatic manufacturing machine in accordance with one of the claims 22 - 26,
**characterised by** at least one catch element (119, 119a) for snap-in fixing of the seating (107) in the mounting that is formed by at least one holder (110, 110a).

28. Automatic manufacturing machine in accordance with claim 27, **characterised by** an actuation slide (127) for actuating and locking the catch element (119a) in the position that fixes the seating (107).

## Revendications

1. Robot de fabrication ou d'assemblage avec rotor (11) pivotant autour d'un axe de machine vertical (V), avec plusieurs réceptions (15) pour éléments structuraux ou modules prévues sur la périphérie du rotor, et avec entraînement de rotor (11) centralisé destiné à déplacer les réceptions (15) de manière cadencée d'une position de travail vers une autre, avec des premiers éléments fonctionnels (5) situés à une position de travail, et avec un dispositif de guidage commun à plusieurs premiers éléments fonctionnels (5), le dispositif étant entraîné par l'entraînement centralisé et enfin, avec des mouvements des premiers éléments fonctionnels autour et/ou dans au moins une direction axiale (A,B), les mouvements étant synchronisés avec le mouvement de rotation cadencé du rotor (11), et **caractérisé en ce que** le dispositif de guidage commun présente pour tous les premiers éléments fonctionnels (5), au moins un élément de queue commun en forme de disque (21, 22) formant une surface de guidage avec laquelle des éléments de guidage (67, 69) de tous les premiers éléments fonctionnels sont solidaires pour générer le mouvement autour ou dans au moins un axe (1, B), **caractérisé en ce que** le disque de guidage (21) a été prévu pour une course en direction de l'axe de la machine (V), contre une tige de levage ou de traction (18, 19) dont l'axe a été disposé parallèlement à l'axe de la machine (V), dans le sens radial et guidé dans un élément central du bâti de la machine (7).

2. Robot de fabrication selon la revendication 1 ou 2, **caractérisé en ce que** un entraînement auxiliaire (28) destiné au couplage d'entraînements de guidage (54, 55, 56) pour les postes de travail (4) a été prévu contre le bâti de la machine (7).

3. Robot de fabrication selon une des revendications précédentes, **caractérisé en ce que** un couplage de sécurité (34) séparant, en cas de dépassement d'un couple de torsion prédéterminé, la corde d'entraînement par désencliquetage a été prévu dans la corde d'entraînement située entre un moteur entraînant le rotor (11) et ce rotor (11), et **caractérisé en ce que** un frein (36) bloquant le rotor lorsque le couplage de sécurité est désencliqueté a été prévu dans la corde d'entraînement, après le couplage de sécurité (34).

4. Robot de fabrication selon une des revendications précédentes, **caractérisé en ce que** au moins un disque de guidage (21, 22) a été guidé de manière à coulisser le long d'autres tiges (19, 18, 16) disposées parallèlement à la tige de levage du disque.

5. Robot de fabrication selon une des revendications précédentes, **caractérisé en ce que** au moins deux disques de guidage (21, 22) ont été disposés l'un au dessus de l'autre ou l'un contre l'autre dans la direction de l'axe de la machine (V), **en ce que** une tige de levage (18, 19) a été raccordée à chaque disque de guidage (21, 22), le disque de guidage correspondant étant fixé à la tige de manière à ne pas pouvoir coulisser dans le sens axial, **en ce que** le premier disque de guidage (21) sur la tige de levage du deuxième disque de guidage a été disposé de manière à pouvoir coulisser dans le sens axial et **en ce que** le deuxième disque de guidage(22) situé sur la tige de levage (18) du premier disque de guidage (21) a été disposé de manière à pouvoir coulisser dans le sens axial.

6. Robot de fabrication selon une des revendications précédentes, **caractérisé en ce que** des tiges de guidage (16) réparties autour de l'axe de la machine (V) ont été prévues. Les axes de ces tiges ont été disposés parallèlement à l'axe de la machine (V), dans le sens radial par rapport à ce même axe, et enfin, **en ce que** les disques de guidage (21, 22) sont guidés de manière à pouvoir coulisser sur ces tiges de guidage (16).

7. Robot de fabrication selon une des revendications précédentes, **caractérisé en ce que** chaque premier élément fonctionnel présente un support (6) contre lequel un outil comme un appareil margeur, une pince et analogue peut être fixé, **en ce que** le support a été prévu contre un traîneau (64) mobile dans une première direction axiale (A), **en ce que** le traîneau (64) a été disposé contre un traîneau auxiliaire (63) pouvant être déplacé dans la deuxième direction de l'axe (B), et **en ce que** chaque premier élément fonctionnel (5) présente un premier dispositif de guidage (67) destiné à déplacer le traîneau (64) dans la première direction de l'axe (A) et un deuxième élément de guidage (69) destiné à déplacer le traîneau (64) dans la deuxième direction de l'axe (B).

8. Robot de fabrication selon une des revendications précédentes, **caractérisé en ce que** les éléments de guidage sont des leviers de guidage (67, 69).

9. Robot de fabrication selon une des revendications précédentes, **caractérisé en ce que** le rapport de chaque élément de guidage (67, 69) peut être réglé.

10. Robot de fabrication selon une des revendications précédentes, **caractérisé en ce que** plus de deux tiges de levage (18, 19) ont été prévues et **en ce que** un disque de guidage (21, 22) a été fixé contre chaque tige de levage.

11. Robot de fabrication selon une des revendications précédentes, **caractérisé en ce que** toutes les tiges de levage ont été transpercés par tous les disques de guidage (21, 22).

12. Robot de fabrication selon une des revendications précédentes, **caractérisé en ce que** les premiers éléments fonctionnels (5) sont des dispositions de levage.

13. Robot de fabrication selon une des revendications précédentes, **caractérisé en ce que** des postes de travail (4) ont été prévus contre le bâti de machine du robot de fabrication. Ces postes présentent, sur une base (50) identique pour toutes les postes de travail, des deuxièmes éléments fonctionnels (53) adaptés au poste.

14. Robot de fabrication selon une des revendications précédentes, **caractérisé en ce que** les deuxièmes unités fonctionnelles (53) sont des admissions.

15. Robot de fabrication selon une des revendications précédentes, **caractérisé en ce que** l'entraînement auxiliaire a été formé par une roue dentée ou une couronne dentée (28) entraînée autour de l'axe de la machine (V) et **en ce que** les entraînements de guidage ont été constitués systématiquement sous la forme d'un mécanisme angulaire (56) avec une roue dentée (58) à l'avant capable de s'engrener avec la roue dentée ou la couronne dentée et avec au moins un arbre (54, 55) à la sortie.

16. Robot de fabrication selon une des revendications précédentes, **caractérisé en ce que** le mécanisme angulaire (54) peut être relié par bride à une ouverture sur un bâti de machine (7) en forme de boîtier.

17. Robot de fabrication selon une des revendications précédentes, **caractérisé en ce que** le mécanisme angulaire (57) a été relié par bride à une surface horizontale ou essentiellement horizontale (7''') du bâti de machine (7).

18. Robot de fabrication selon une des revendications précédentes, **caractérisé en ce que** un entraînement de la croix de Malte (12, 13) a été prévu dans la corde d'entraînement située entre un moteur entraînant le rotor (11) et le rotor (11).

19. Robot de fabrication selon une des revendications précédentes, **caractérisé en ce que** un mécanisme (32) échangeable destiné à produire des temps de déplacement et d'arrêt divers a été prévu dans la corde d'entraînement située entre le moteur entraînant le rotor (11) et ce rotor (11).

20. Robot de fabrication selon une des revendications précédentes, **caractérisé en ce que** le poste de travail (5) est composé d'une base normalisée (50) et d'une unité fonctionnelle (53) montée sur cette base.

21. Robot de fabrication selon une des revendications précédentes, **caractérisé en ce que**, à la base, un arbre (54) pouvant être entraîné et destiné à un entraînement de guidage du poste de travail (4).

22. Robot de fabrication selon une des revendications précédentes, **caractérisé par** plusieurs réceptions (107) pour éléments structuraux ou modules prévues sur la périphérie (104') du rotor ou d'un élément de table (104) pivotant, les réceptions (107) étant fixées à l'élément de table par l'intermédiaire de supports (110'), de telle sorte que les réceptions puisent être enfichées dans le sens radial par rapport à l'axe de l'élément de table (104).

23. Robot de fabrication selon la revendication 22, **caractérisé en ce que** les supports (110') ou les montants (110, 110a) qui les forment présentent des évidements (111, 112) en forme de poches qui se chevauchent avec épousement de formes avec un côté de l'élément de table (104) ou avec les réceptions (107) soutenant les supports (110'), sur un côté opposé, et qui forment au moins une première installation (115) pour l'orientation précise et / ou le positionnement des réceptions (107) à la périphérie (104').

24. Robot de fabrication selon la revendication 22 ou 23, **caractérisé en ce que** les supports (110') ou les montants (110, 110a) forment chacun au moins une seconde installation (114) destinée à fixer la distance radiale entre les réceptions (107) et l'axe (V) de l'élément de table (104).

25. Robot de fabrication selon une des revendications 22 - 24, **caractérisé en ce que** les réceptions (107) forment des surfaces opposées pour les installations (115, 114).

26. Robot de fabrication selon une des revendications 22 - 25, **caractérisé en ce que** toutes les installations pour chaque réception (107) ont été prévues sur un montant commun (110, 110a).

27. Robot de fabrication selon une des revendications 22 - 26, **caractérisé en ce que** au moins un élément d'ancrage (119, 119a) destiné à fixer, par ancrage, la réception (107) dans le support formé par au moins un montant (110, 110a) a été prévu.

28. Robot de fabrication selon la revendication 27, **caractérisé par** un coulisseau de manoeuvre (127) destiné à manier et à verrouiller l'élément d'ancrage (119a) dans la position fixant la réception (107).
